# EUROPÄISCHE PATENTSCHRIFT

(11) **EP 1 364 404 B1**
(45) Veröffentlichungstag und Bekanntmachung des Hinweises auf die Patenterteilung: **12.10.2011**
(21) Anmeldenummer: 02719629.4
(22) Anmeldetag: 15.02.2002
(51) Int. Cl.: H01L 23/522, H01L 21/768

(54) **HOHLRAUMSTRUKTUR IN EINER INTERGRIERTEN SCHALTUNG UND VERFAHREN ZUM HERSTELLEN EINER HOHLRAUMSTRUKTUR IN EINER INTEGRIERTEN SCHALTUNG**
HOLLOW STRUCTURE IN AN INTEGRATED CIRCUIT AND METHOD FOR PRODUCING SUCH A HOLLOW STRUCTURE IN AN INTEGRATED CIRCUIT
STRUCTURE CREUSE DANS UN CIRCUIT INTEGRE ET PROCEDE D'OBTENTION D'UNE TELLE STRUCTURE DANS UN CIRCUIT INTEGRE

(30) Priorität: 01.03.2001 DE 10109778
(43) Veröffentlichungstag der Anmeldung: 26.11.2003
(73) Patentinhaber: Infineon Technologies AG, 85579 Neubiberg (DE)
(72) Erfinder: PAMLER, Werner, 80686 München (DE); SCHWARZL, Siegfried, 85579 Neubiberg (DE); GABRIC, Zvonimir, 85604 Zorneding (DE)
(74) Vertreter: Viering, Jentschura & Partner
(86) Internationale Anmeldenummer: PCT/DE2002/000554
(87) Internationale Veröffentlichungsnummer: WO 2002/071482

(56) Entgegenhaltungen:
- US-A- 5 407 860
- US-A- 5 512 775
- US-A- 5 539 243
- US-A- 5 990 557
- PATENT ABSTRACTS OF JAPAN vol. 1997, no. 06, 30. Juni 1997 (1997-06-30) & JP 09 055431 A (NIPPON STEEL CORP), 25. Februar 1997 (1997-02-25)
- UEDA T ET AL: "A novel air gap integration scheme for multi-level interconnects using self-aligned via plugs" VLSI TECHNOLOGY, 1998. DIGEST OF TECHNICAL PAPERS. 1998 SYMPOSIUM ON HONOLULU, HI, USA 9-11 JUNE 1998, NEW YORK, NY, USA,IEEE, US, 9. Juni 1998 (1998-06-09), Seiten 46-47, XP010291198 ISBN: 0-7803-4770-6 in der Anmeldung erwähnt
- FLEMING J G ET AL: "LOWERING OF INTRALEVEL CAPACITANCE USING AIR GAP STRUCTURES" CONFERENCE PROCEEDINGS ULSI, XX, XX, 1997, Seiten 471-477, XP000973380 in der Anmeldung erwähnt

## Beschreibung

Die Erfindung betrifft eine Hohlraumstruktur in einer integrierten Schaltung und ein Verfahren zum Herstellen einer Hohlraumstruktur in einer integrierten Schaltung.

Integrierte Schaltungsanordnungen werden mit immer höherer Packungsdichte erzeugt. Dies hat zur Folge, dass Leiterbahnen in Metallisierungsebenen einen immer kleineren Abstand voneinander aufweisen. Dadurch steigen Kapazitäten, die zwischen den Leiterbahnen gebildet werden und zu hohen Signallaufzeiten, hoher Verlustleistung und Übersprechen führen. Bisher wurde zur Isolation zwischen den Leiterbahnen hauptsächlich SiO₂ als Dielektrikum verwendet, dessen relative Dielektrizitätskonstante εᵣ = 3,9 beträgt.

Es sind einige Methoden zur Erniedrigung der relativen Dielektrizitätskonstante εᵣ und damit zur Erniedrigung der Kapazität zwischen Leiterbahnen innerhalb einer Leiterbahnebene bekannt, beispielsweise aus [1] oder [2].

Gemäß dem zitierten Stand der Technik werden Hohlräume zwischen den Leiterbahnen innerhalb einer,Leiterbahnebene erzeugt. Das isolierende Dielektrikum, das die Kapazität zwischen den Leiterbahnen bestimmt, weist somit eine relative Dielektrizitätskonstante εᵣ auf, die fast gleich Eins ist. Die Leiterbahnen selbst sind dabei zur Isolation oben und unten von massiven SiO₂-Schichten eingeschlossen.

Solche Hohlraumstrukturen sind aus den Dokumenten US-A- 5 539 243, JP-A-09 055 431 und US-A-5 407 860 bekannt.

Da zur Gesamtkapazität zwischen innerhalb einer Schicht benachbarten Leiterbahnen auch in nicht unerheblichem Maße die Kapazitäten der darunter und darüber liegenden isolierenden Schichten beitragen und diese isolierenden Schichten nach wie vor aus SiO₂-Vollmaterial bestehen, hat die hohe relative Dielektrizitätskonstante εᵣ dieser isolierenden Schichten einen beträchtlichen Einfluss auf die Gesamtkapazität zwischen den benachbarten Leiterbahnen. Die hohe relative Dielektrizitätskonstante εᵣ der isolierenden Schichten aus SiO₂-Vollmaterial wirkt sich zusätzlich ganz besonders auf die Kapazität von in verschiedenen Schichten benachbart angeordneten Leiterbahnen aus.

Der Erfindung liegt somit das Problem zugrunde, eine Hohlraumstruktur in einer integrierten.Schaltung sowie ein Verfahren zur Herstellung einer Hohlraumstruktur in einer integrierten Schaltung anzugeben, bei der/dem die isolierende Schicht zwischen Leiterbahnen aus verschiedenen Ebenen eine kleine Kapazität auf Grund einer kleinen relativen Dielektrizitätskonstante εᵣ sowie die Möglichkeit zur Bildung von Kontakten aufweist.

Das Problem wird durch eine Hohlraumstruktur in einer integrierten Schaltung sowie durch ein Verfahren zur Herstellung einer Hohlraumstruktur in einer integrierten Schaltung mit den Merkmalen gemäß den unabhängigen Patentansprüchen gelöst.

Eine erfindungsgemäße Hohlraumstruktur in einer integrierten Schaltung weist auf eine erste Schicht, eine erste Schichtoberfläche und nebeneinander angeordnete Stege auf der ersten Schichtoberfläche, wobei die nebeneinander angeordneten Stege Zwischenräume einschließen und eine zweite Schicht eines ersten Isolationsmaterials und eine auf der zweiten Schicht angeordnete dritte Schicht eines zweiten Isolationsmaterials aufweisen. Weiterhin weist die Hohlraumstruktur auf eine zumindest einige der Zwischenräume abschließende vierte Schicht aus einem dritten Isolationsmaterial, das sich nicht auf dem ersten Isolationsmaterial abscheiden lässt. Des weiteren ist bei der Hohlraumstruktur die vierte Schicht auf der dritten Schicht angeordnet. Die vierte Schicht weist eine zweite Schichtoberfläche auf. Schließlich sind bei der Hohlraumstruktur Zwischenräume, die nicht mittels der vierten Schicht abgeschlossen sind, mit elektrisch leitendem Material angefüllt.

Bei einem Verfahren zur Herstellung einer Hohlraumstruktur in einer integrierten Schaltung wird eine zweite Schicht aus einem ersten Isolationsmaterial auf einer.ersten Schichtoberfläche einer ersten Schicht aufgebracht. Eine dritte Schicht aus einem zweiten Isolationsmaterial wird auf der zweiten Schicht aufgebracht, wobei die dritte Schicht eine zu der ersten Schichtoberfläche parallel angeordnete zweite Schichtoberfläche erhält. Aus der zweiten Schicht und der dritten Schicht werden nebeneinander angeordnete Stege mit Zwischenräumen gebildet. Ein drittes Isolationsmaterial wird an den nebeneinander angeordneten Stegen selektiv auf der dritten Schicht aufgebracht, wodurch eine vierte Schicht zwischen und über den nebeneinander angeordneten Stegen gebildet wird. Parallel zur ersten Schichtoberfläche wird die vierte Schicht teilweise entfernt, bis die zweite Schichtoberfläche freigelegt ist. Über einigen Zwischenräumen wird die vierte Schicht vollständig entfernt und schließlich werden diese Zwischenräume mit elektrisch leitendem Material zur Bildung von elektrischen Kontakten zwischen der ersten Schichtoberfläche und der zweiten Schichtoberfläche gefüllt, wodurch sich eine Hohlraumstruktur ergibt.

Ein Vorteil der Erfindung kann darin gesehen werden, dass mittels der Hohlraumstruktur als isolierende Schicht zwischen benachbarten Leiterbahnen die relative Dielektrizitätskonstante εᵣ der isolierenden Schicht zwischen den benachbarten Leiterbahnen fast gleich Eins ist und somit die Kapazität zwischen diesen Leiterbahnen reduziert wird. Die Reduzierung der Kapazität wirkt sich sowohl auf innerhalb einer Schicht benachbarte Leiterbahnen als auch auf in verschiedenen Schichten benachbart angeordnete Leiterbahnen aus. Damit ermöglicht die Hohlraumstruktur eine erhebliche Reduzierung der Gesamtkapazität innerhalb einer integrierten Schaltung.

Ein weiterer Vorteil der Hohlraumstruktur ist die Bereitstellung von einfach herstellbaren Kontakten zwischen in verschiedenen Schichten angeordneten Leiterbahnen. Mittels der nebeneinander angeordneten Stege und vor allem mittels der von diesen Stegen eingeschlossenen Zwischenräume ist es möglich, bei einigen der Zwischenräume die vierte Schicht gezielt zwischen benachbarten Stegen zu entfernen und dadurch diese Zwischenräume zu öffnen, um dann die geöffneten Zwischenräume mit elektrisch leitfähigem Material anzufüllen und somit Kontakte zwischen einer Schicht unterhalb und einer Schicht oberhalb der Hohlraumstruktur herzustellen.

Vorzugsweise bilden die abgeschlossenen Zwischenräume Hohlräume zwischen den nebeneinander angeordneten Stegen, der ersten Schichtoberfläche und der vierten Schicht. Diese Hohlräume sind nach Fertigstellung der Hohlraumstruktur mit Luft gefüllt und weisen somit eine relative Dielektrizitätskonstante εᵣ von fast gleich Eins auf. Somit ist die Kapazitätswirkung der Hohlraumstruktur sehr gering.

In einer bevorzugten Weiterbildung der erfindungsgemäßen Hohlraumstruktur sind die Hohlräume zur elektrischen Isolierung zwischen der ersten Schichtoberfläche und der zweiten Schichtoberfläche vorgesehen. Als Alternative zu einer isolierenden Schicht aus Vollmaterial zwischen zwei sogenannten Metallisierungsebenen, also Schichten mit einer oder mehreren integrierten Leiterbahnen und/oder Halbleiterbauelementen, kommt nun die Hohlraumstruktur zur Anwendung, wodurch die Kapazität zwischen benachbarten Leiterbahnen und/oder Halbleiterbauelementen aus verschiedenen Metallisierungsebenen erheblich reduziert und ein Übersprechen.der in den Leiterbahnen geführten und/oder Halbleiterbauelementen verarbeiteten Signale verringert wird.

Vorzugsweise ist die erste Schichtoberfläche teilweise elektrisch leitend. Die erste Schicht kann dabei beispielsweise ein Substrat mit einem oder mehreren integrierten Halbleiterbauelementen sein. Alternativ dazu kann die erste Schicht beispielsweise auch eine Metallisierungsebene mit einer oder mehreren Leiterbahnen sein. Für die Erfindung sind die exakte interne Struktur sowie die Beschaffenheit der ersten Schicht unerheblich, solange die erste Schicht eine Schichtoberfläche aufweist, die vorzugsweise in einer Ebene liegt.

In einer bevorzugten Weiterbildung der erfindungsgemäßen Hohlraumstruktur sind die mit elektrisch leitendem Material angefüllten Zwischenräume als elektrische Kontakte zwischen der ersten Schichtoberfläche und der zweiten Schichtoberfläche vorgesehen. Die Kontakte dienen dabei einer gezielten elektrischen Verbindung zwischen einzelnen Leiterbahnen und/oder Halbleiterbauelementen, ohne auf die isolierende Wirkung der Hohlraumstruktur gegenüber den übrigen Leiterbahnen/Halbleiterbauelementen zu verzichten.

Die Hohlräume der Hohlraumstruktur sind vorzugsweise zur elektrischen Isolierung zwischen Kontakten in verschiedenen Zwischenräumen vorgesehen. Die elektrische Isolierung von Kontakten untereinander ist der elektrischen Isolierung zwischen benachbarten Leiterbahnen vergleichbar und dient der Reduzierung der Kapazität zwischen verschiedenen Signalwegen.

Vorzugsweise sind die nebeneinander angeordneten Stege gitterförmig angeordnet. Dies hat den Vorteil, dass die Form der Zwischenräume und damit die Form bzw. der Durchmesser der elektrischen Kontakte vorherbestimmt werden kann. Des weiteren bietet eine gitterförmige Anordnung die Möglichkeit, bei geringem Materialaufwand für die Stege eine stabile Hohlraumstruktur aufzubauen und trotzdem eine relative Dielektrizitätskonstante εᵣ mit einem Wert von fast gleich Eins zu erhalten.

Die nebeneinander angeordneten Stege und Zwischenräume bilden vorzugsweise eine ebene Hohlraumstruktur mit einer ebenen zweiten Schichtoberfläche. Weiterhin können mehrere dieser ebenen Hohlraumstrukturen übereinander angeordnet sein. Dies hat den Vorteil, dass insgesamt eine breite isolierende Schicht mit durchgängigen Kontakten gebildet werden kann, wobei diese breite isolierende Schicht zur Stabilisierung jedoch aus mehreren, unterschiedlich aufgebauten ebenen Hohlraumstrukturen besteht.

Bei einem erfindungsgemäßen Verfahren zur Herstellung einer Hohlraumstruktur werden die nebeneinander angeordneten Stege bevorzugt mittels Lithographie und Ätzung erzeugt. Dazu werden die zweite Schicht und die dritte Schicht zunächst flächig übereinander über der ersten Schichtoberfläche aufgebracht. Dann wird die Struktur der nebeneinander angeordneten Stege mittels Lithographie sowohl in die zweite Schicht als auch in die dritte Schicht "geschrieben" und schließlich mittels Ätzung freigelegt. Unter Anwendung einer geeigneten Lithographiemaske wird die Struktur der nebeneinander angeordneten Stege und somit die Form des Gitters vorherbestimmt.

In einer bevorzugten Weiterbildung des erfindungsgemäßen Verfahrens werden mittels einer selektiven Abscheidung des dritten Isolationsmaterials in den Zwischenräumen Hohlräume zwischen den nebeneinander angeordneten Stegen, der ersten Schichtoberfläche und der vierten Schicht gebildet. Werden die drei Isolationsmaterialien geeignet gewählt, kann erreicht werden, dass sich das dritte Isolationsmaterial selektiv nur an dem zweiten Isolationsmaterial und nicht an dem ersten Isolationsmaterial anlagert. Die vierte Schicht bildet folglich anschaulich eine Art Deckel für die zwischen den nebeneinander angeordneten Stegen befindlichen Zwischenräume.

Gemäß einer anderen anschaulichen Beschreibung bildet die vierte Schicht, welche selektiv an der dritten Schicht angelagert ist, zusammen mit der dritten Schicht und der zweiten Schicht eine pilzartige Struktur. Zu diesem Zweck werden bevorzugt folgende Materialien gewählt: für die zweite Schicht Siliziumnitrid (Si₃N₄) als erstes Isolationsmaterial, für die dritte Schicht auf Silan (SiH₄) basierendes, plasmaangeregtes Siliziumdioxid (SiO₂) als zweites Isolationsmaterial und für die vierte Schicht auf ozon-aktiviertem Tetra-Ethyl-Ortho-Silicat (O₃/TEOS) basierendes Siliziumdioxid (SiO₂) als drittes Isolationsmaterial. Dabei wird das auf Silan (SiH₄) basierende, plasmaangeregte Siliziumdioxid (SiO₂) üblicherweise in einem PECVD-Prozess (PECVD = Plasma enhanced chemical vapor deposition = plasmaangeregte chemische Gasphasenabscheidung) abgeschieden. Selbstverständlich können auch andere, elektrisch isolierende Materialien gewählt werden, wenn diese die oben beschriebene Selektivität hinsichtlich ihres Anlagerungsverhaltens zeigen.

Zum Freilegen der dritten Schicht wird in einer bevorzugten Ausführungsform des erfindungsgemäßen Verfahrens die vierte Schicht mittels chemisch-mechanischen Polierens teilweise entfernt. Da die vierte Schicht nicht nur parallel sondern auch vertikal zur ersten Schichtoberfläche, also auch oberhalb der dritten Schicht, aufgebracht wird, kann mittels eines Abtragens der vierten Schicht parallel zur ersten Schichtoberfläche bis zum Erreichen der dritten Schicht eine einheitliche ebene zweite Schichtoberfläche geschaffen werden, auf welcher weitere Schichten aufgebracht werden können.

Bei dem erfindungsgemäßen Verfahren wird zur Freilegung einiger Zwischenräume vorzugsweise die vierte Schicht über den Zwischenräumen mittels Lithographie und Ätzung entfernt, wodurch diese Zwischenräume wieder geöffnet werden. Dazu ist die vorherige chemisch-mechanische Polierung der vierten Schicht besonders vorteilhaft, da mittels dieser eine zur ersten Schichtoberfläche parallele Oberfläche der dritten Schicht freigelegt wird. Auf diese Weise werden die Struktur der nebeneinander angeordneten Stege und folglich die Positionen der Zwischenräume sichtbar gemacht. Mittels der Entfernung der vierten Schicht über einigen Zwischenräumen ergeben sich in der Hohlraumstruktur Öffnungen, die von der zweiten Schichtoberfläche bis zur ersten Schichtoberfläche reichen und anschließend zur Bildung von Kontakten mit elektrisch leitendem Material gefüllt werden können.

Ein Ausführungsbeispiel der Erfindung ist in den Figuren dargestellt und wird im folgenden näher erläutert. Dabei bezeichnen gleiche Bezugszeichen gleiche Komponenten.

Es zeigen
- Figur 1: einen Querschnitt durch eine Hohlraumstruktur gemäß einem Ausführungsbeispiel der Erfindung;
- Figur 2: eine Draufsicht auf die Hohlraumstruktur aus Fig.1;
- Figur 3: einen Querschnitt durch eine noch nicht fertiggestellte Hohlraumstruktur gemäß Fig.1 zu einem ersten Zeitpunkt während der Durchführung des Herstellungsverfahrens gemäß dem Ausführungsbeispiel der Erfindung;
- Figur 4: einen Querschnitt durch eine noch nicht fertiggestellte Hohlraumstruktur gemäß Fig.1 zu einem zweiten Zeitpunkt während der Durchführung des Herstellungsverfahrens gemäß dem Ausführungsbeispiel der Erfindung;
- Figur 5: eine Draufsicht auf die Hohlraumstruktur aus Fig.4;
- Figur 6: einen Querschnitt durch eine noch nicht fertiggestellte Hohlraumstruktur gemäß Fig.1 zu einem dritten Zeitpunkt während der Durchführung des Herstellungsverfahrens gemäß dem Ausführungsbeispiel der Erfindung;
- Figur 7: eine Draufsicht auf die Hohlraumstruktur aus Fig.6;
- Figur 8: einen Querschnitt durch eine noch nicht fertiggestellte Hohlraumstruktur gemäß Fig.1 zu einem vierten Zeitpunkt während der Durchführung des Herstellungsverfahrens gemäß dem Ausführungsbeispiel der Erfindung;
- Figur 9: einen Querschnitt durch eine noch nicht fertiggestellte Hohlraumstruktur gemäß Fig.1 zu einem fünften Zeitpunkt während der Durchführung des Herstellungsverfahrens gemäß dem Ausführungsbeispiel der Erfindung;
- Figur 10: eine Draufsicht auf die Hohlraumstruktur aus Fig.9;
- Figur 11: einen Querschnitt durch eine noch nicht fertiggestellte Hohlraumstruktur gemäß Fig.1 zu einem sechsten Zeitpunkt während der Durchführung des Herstellungsverfahrens gemäß dem Ausführungsbeispiel der Erfindung;
- Figur 12: eine Draufsicht auf die Hohlraumstruktur aus Fig.11; und
- Figur 13: einen vergrößerten Ausschnitt aus dem Querschnitt durch die Hohlraumstruktur aus Fig.1.

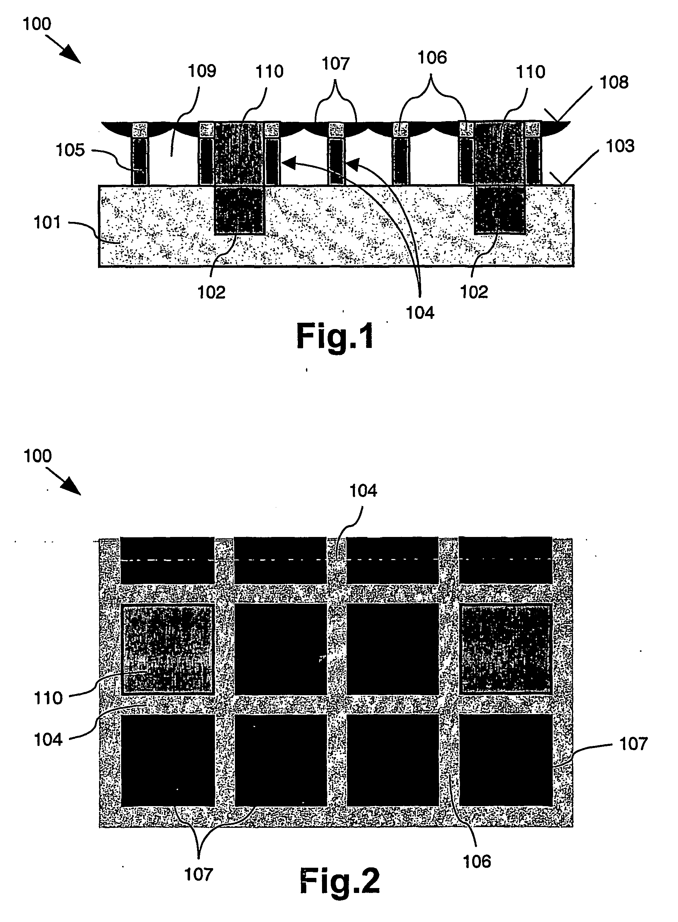

**Fig. 1** zeigt einen Querschnitt durch eine Hohlraumstruktur 100 gemäß einem Ausführungsbeispiel der Erfindung.

Die Hohlraumstruktur 100 weist ein.Substrat mit integrierten Leiterbahnen 102 und einer als erste Schichtoberfläche 103 ausgebildeten Substratoberfläche als erste Schicht 101 auf. Als Substratmaterial wurde ein isolierendes Material, vorzugsweise Siliziumdioxid (SiO₂), gewählt. Die erste Schicht kann alternativ auch eine Struktur von integrierten Leiterbahnen mit dazwischen angeordneten Hohlräumen innerhalb der ersten Schicht 101 aufweisen.

Auf der ersten Schichtoberfläche 103 befinden sich nebeneinander angeordnete Stege 104, welche eine zweite Schicht 105 und eine dritte Schicht 106 aufweisen. Die nebeneinander angeordneten Stege 104 sind in diesem Ausführungsbeispiel gitterförmig mit jeweils konstantem Abstand zueinander und im wesentlichen gleich großen quadratischen Zwischenräumen angeordnet. Die zweite Schicht 105 weist ein erstes Isolationsmaterial, gemäß diesem Ausführungsbeispiel Siliziumnitrid (Si₃N₄), auf. Die dritte schicht 106 weist ein zweites Isolationsmaterial auf, wobei gemäß diesem Ausführungsbeispiel auf Silan (SiH₄) basierendes, plasmaangeregtes (PECVD-Prozess) Siliziumdioxid (SiO₂) verwendet wird.

Auf der dritten Schicht 106 zwischen den nebeneinander angeordneten Stegen 104 befindet sich eine vierte Schicht 107 aus einem dritten Isolationsmaterial, gemäß diesem Ausführungsbeispiel auf ozon-aktiviertem Tetra-Ethyl-Ortho-Silicat (O₃/TEOS) basierendes Siliziumdioxid (SiO₂). Auf Grund der geeigneten Wahl der Isolationsmaterialien wird erreicht, dass sich die vierte Schicht 107 selektiv nur an der dritten Schicht 106 bildet. Die vierte Schicht 107 sowie die dritte Schicht 106 haben eine gemeinsame Oberfläche, welche im Folgenden als zweite Schichtoberfläche 108 bezeichnet wird und zur ersten Schichtoberfläche 103 parallel ist.

Wegen der selektiven Anlagerung der vierten Schicht 107 an der dritten Schicht 106 werden Hohlräume 109 zwischen der ersten Schichtoberfläche 103, den nebeneinander angeordneten Stegen 104 und der vierten Schicht 107 eingeschlossen. Zwischen einigen der nebeneinander angeordneten Stege 104 ist die vierte Schicht 107 wieder entfernt und die zwischen den nebeneinander angeordneten Stegen 104 befindlichen freigelegten Bereiche sind mit elektrisch leitendem Material zur Bildung von elektrischen Kontakten 110 angefüllt.

Über der zweiten Schichtoberfläche 108 können nach Belieben weitere Metallisierungsebenen aufgebracht werden. Die erfindungsgemäße Hohlraumstruktur 100 bietet einerseits sowohl eine erhöhte Isolationswirkung zwischen den Leiterbahnen 102 mittels der Anordnung von elektrisch isolierenden Hohlräumen 109, welche die relative Dielektrizitätskonstante εᵣ zwischen den Leiterbahnen 102 reduzieren, als auch eine erhöhte Isolationswirkung zwischen der ersten Schichtoberfläche 103 und der zweiten Schichtoberfläche 108. Andererseits bietet die erfindungsgemäße Hohlraumstruktur 100 die Möglichkeit einer gezielten Bereitstellung von elektrischen Kontakten 110 zwischen der ersten Schichtoberfläche 103 und der zweiten Schichtoberfläche 108.

Der Abstand zweier benachbarter nebeneinander angeordneter Stege 104 sowie die Dicke der nebeneinander angeordneten Stege 104 sollten so gewählt werden, dass die erfindungsgemäße Hohlraumstruktur 100 eine gute Tragfähigkeit für über der zweiten Schichtoberfläche 108 angeordnete weitere Schichten und Metallisierungsebenen aufweist. Gemäß diesem Ausführungsbeispiel weisen die nebeneinander angeordneten Stege 104 jeweils eine Dicke von 100 nm und einen Abstand von 500 nm auf.

Wegen der Selektivität des dritten Isolationsmaterials hinsichtlich des Anlagerungsverhaltens ist die Bildung der vierten Schicht 107 mit dem Entstehen von Wülsten an den oberen Enden der nebeneinander angeordneten Stege 104 vergleichbar. Nach einer gewissen Wachstumszeit überlappen sich die Wülste von benachbarten nebeneinander angeordneten Stegen 104 und bilden eine geschlossene vierte Schicht 107. An den Stellen, an denen sich Wülste überlappen, ist die vierte Schicht 107 am dünnsten. Da zur Bildung der einheitlichen und zur ersten Schichtoberfläche 103 parallelen zweiten Schichtoberfläche 108 die vierte Schicht 104 teilweise wieder entfernt wird, muss darauf geachtet werden, dass der Abstand der nebeneinander angeordneten Stege 104 nicht zu groß gewählt wird, damit die vierte Schicht 107 nicht an den Überlappungsstellen der Wülste wieder aufbricht.

**Fig. 2** zeigt eine Draufsicht auf die Hohlraumstruktur 100 aus Fig.1. Fig.2 stellt die in einem quadratischen Gitter befindlichen nebeneinander angeordneten Stege 104 mit der an der zweiten Schichtoberfläche 108 sichtbaren dritten Schicht 106 dar.

Die meisten quadratischen Zwischenräume zwischen den nebeneinander angeordneten Stegen 104 sind mittels der vierten Schicht 107 bedeckt und schließen Hohlräume 109 ein. Einige der quadratischen Zwischenräume sind jedoch mit elektrisch leitendem Material gefüllt und bilden Kontakte 110 zwischen der ersten Schichtoberfläche 103 und der zweiten Schichtoberfläche 108.

Die Form des Gitters, welches von den nebeneinander angeordneten Stegen 104 gebildet wird, ist beliebig. Es sind ebenso gut Gitterformen möglich, die zwischen den nebeneinander angeordneten Stegen 104 sechseckige Zwischenräume oder Zwischenräume mit anderen Formen bilden.

Im Folgenden wird schrittweise ein Verfahren zur Bildung der erfindungsgemäßen Hohlraumstruktur 100 beschrieben.

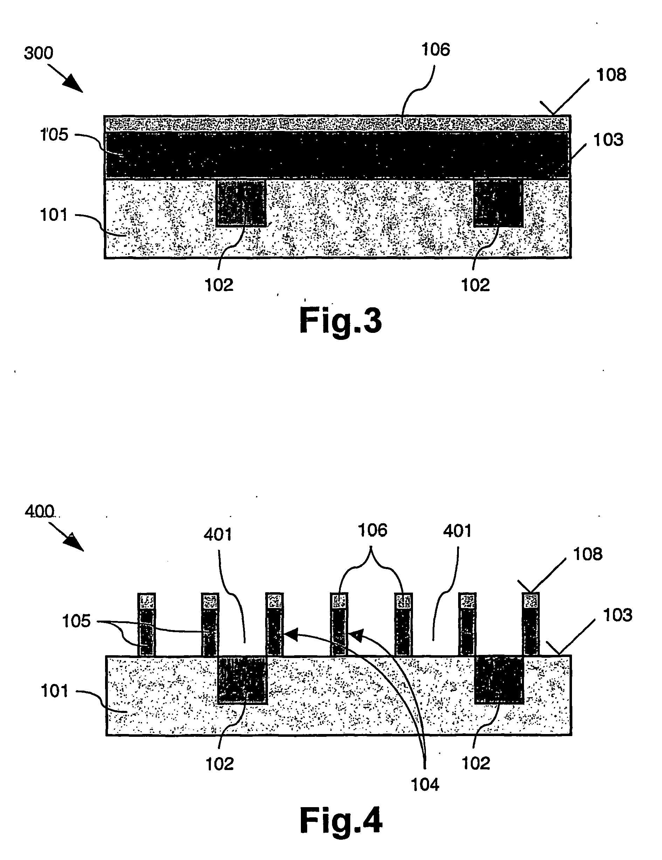

In **Fig. 3** ist ein Querschnitt durch eine noch nicht fertiggestellte Hohlraumstruktur 300 zu einem ersten Zeitpunkt während der Durchführung des Herstellungsverfahrens gemäß dem Ausführungsbeispiel der Erfindung gezeigt.

Als erste Schicht 101 wird ein Substrat mit integrierten Leiterbahnen 102 und einer als erste Schichtoberfläche 103 ausgebildete Substratoberfläche verwendet. Das Substratmaterial ist Siliziumdioxid (SiO₂).

Auf der ersten Schichtoberfläche 103 wird eine zweite Schicht 105 aus Siliziumnitrid (Si₃N₄) mittels eines üblichen Standardverfahrens flächig aufgebracht. Auf der zweiten Schicht 105 wird eine dritte Schicht 106 aus Siliziumdioxid (SiO₂) mittels eines auf Silan (SiH₄) basierenden PECVD-Prozesses flächig aufgewachsen. Die dritte Schicht 106 schließt mit einer zweiten Schichtoberfläche 108 parallel zur ersten Schichtoberfläche 103 ab.

Die Gesamtdicke der zweiten Schicht 105 und der dritten Schicht 106 entspricht der gewünschten späteren Tiefe der Kontakte 110 oder kann an die notwendigen Erfordernisse zur Gewährleistung einer ausreichenden Isolationsfestigkeit angepasst werden. In diesem Ausführungsbeispiel beträgt die Gesamtdicke 400 nm bei einer Dicke von 100 nm für die dritte Schicht 106.

**Fig.4** zeigt einen Querschnitt durch eine noch nicht fertiggestellte Hohlraumstruktur 400 zu einem zweiten Zeitpunkt während der Durchführung des Herstellungsverfahrens gemäß dem Ausführungsbeispiel der Erfindung.

Mittels Lithographie und anschließender Ätzung der zweiten Schicht 105 und der dritten Schicht 106 wird eine gitterförmige Struktur gebildet, welche aus der zweiten Schicht 105 und der dritten Schicht 106 bestehende nebeneinander angeordnete Stege 104 aufweist. Die nebeneinander angeordneten Stege 104 haben jeweils gleiche Abstände zueinander und schließen Zwischenräume 401 ein. Die Zwischenräume 401 reichen bis zur ersten Schichtoberfläche 103.

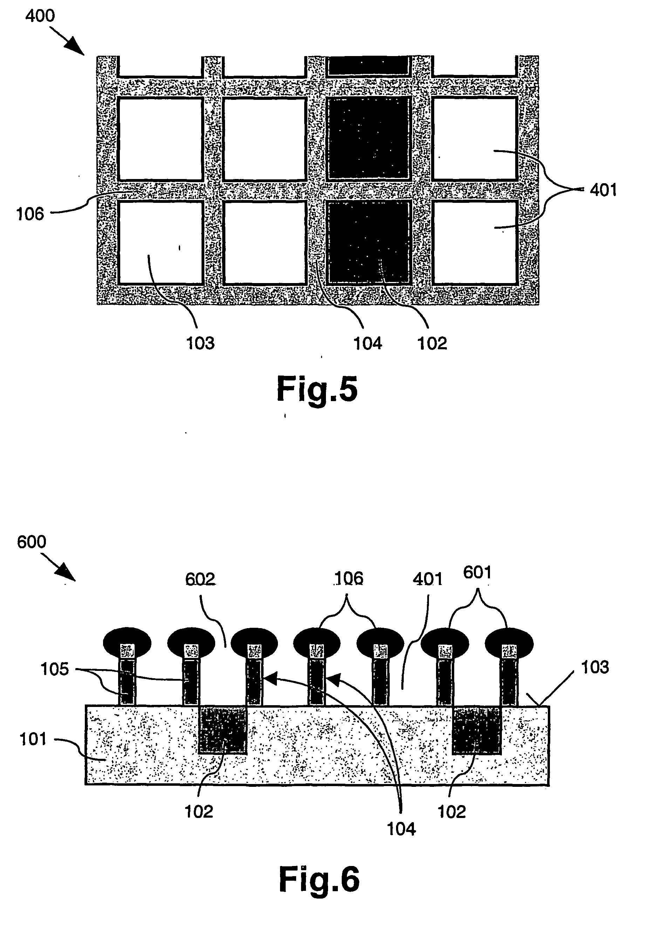

**Fig.5** zeigt eine Draufsicht auf die Hohlraumstruktur 400 aus Fig.4. Fig.5 zeigt die quadratische Form der Zwischenräume 401 zwischen den nebeneinander angeordneten Stegen 104. Da die Zwischenräume 401 bis zur ersten Schichtoberfläche 103 reichen, ist in einigen Zwischenräumen 401 die darunter liegende Leiterbahn 102 freigelegt.

In **Fig.6** ist ein Querschnitt durch eine noch nicht fertiggestellte Hohlraumstruktur 600 zu einem dritten Zeitpunkt während der Durchführung des Herstellungsverfahrens gemäß dem Ausführungsbeispiel der Erfindung gezeigt.

An den nebeneinander angeordneten Stegen 104 wird selektiv an der dritten Schicht 106 ein drittes Isolationsmaterial aufgebracht, welches an den oberen Enden der nebeneinander angeordneten Stege 104 Wülste 601 bildet. Die Wülste 601 verengen an den oberen Enden der nebeneinander angeordneten Stege 104 die dazwischen befindlichen Zwischenräume 401, wodurch die Zwischenräume 401 zuwachsende Öffnungen 602 in der Nähe der dritten Schicht 106 aufweisen.

Als drittes Isolationsmaterial wird Siliziumdioxid (SiO₂) verwendet, welches auf ozon-aktiviertem Tetra-Ethyl-Ortho-Silicat (O₃/TEOS) basiert und in einem Vakuumprozess abgeschieden wird. Auf Grund der gezielten Wahl des ersten Isolationsmaterials (Si₃N₄) für die zweite Schicht 105 und des zweiten Isolationsmaterials (SiO₂) für die dritte Schicht 106 und auf Grund des gewählten O₃/TEOS-Vakuumprozesses wird das dritte Isolationsmaterial (SiO₂) nur an der dritten Schicht 106 zur Bildung der Wülste 601 selektiv abgeschieden.

Für die Bildung einer erfindungsgemäßen Hohlraumstruktur 100 können statt der drei gewählten Isolationsmaterialien sowie deren Herstellungsprozesse auch andere isolierende Materialien und Herstellungsprozesse verwendet werden.

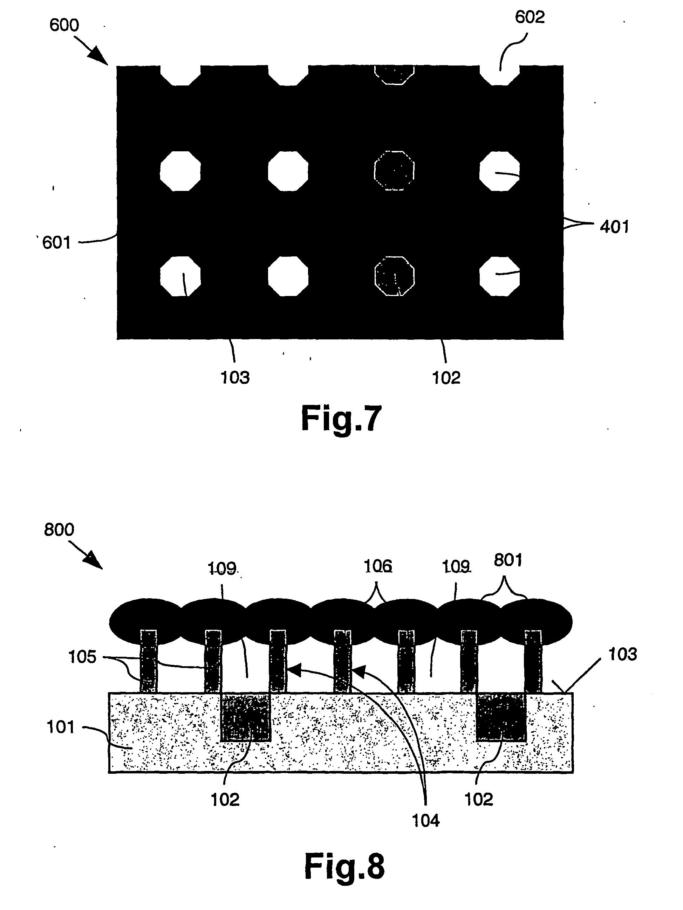

**Fig.7** zeigt eine Draufsicht auf die Hohlraumstruktur 600 aus Fig.6. Das abgeschiedene dritte Isolationsmaterial überdeckt die nebeneinander angeordneten Stege 104 und damit die dritte Schicht 106. Mittels des abgeschiedenen dritten Isolationsmaterials bilden sich, wie in Fig.6 bereits beschrieben, Wülste 601, welche mit zuwachsenden Öffnungen 602 die Zwischenräume 401 Schritt für Schritt bedecken. Durch die zuwachsenden Öffnungen 602 hindurch ist noch die erste Schichtoberfläche 103 mit der integrierten Leiterbahn 102 sichtbar.

**Fig.8** zeigt einen Querschnitt durch eine noch nicht fertiggestellte Hohlraumstruktur 800 zu einem vierten Zeitpunkt während der Durchführung des Herstellungsverfahrens gemäß dem Ausführungsbeispiel der Erfindung.

Drittes Isolationsmaterial (SiO₂) wird, wie in Fig.6 bereits beschrieben, weiterhin selektiv an den Wülsten 601 abgeschieden, wodurch sich eine Schicht.aus zugewachsenen Wülsten 801 über der dritten Schicht 106 bildet. Die Schicht aus zugewachsenen Wülsten 801 hat keine ebene, zur ersten Schichtoberfläche 103 parallele Oberfläche, überdeckt jedoch vollständig die Zwischenräume 401. Aus den Zwischenräumen 401 entstehen somit Hohlräume 109 zwischen der ersten Schichtoberfläche 103, den nebeneinander angeordneten Stegen 104 und der Schicht aus zugewachsenen Wülsten 801.

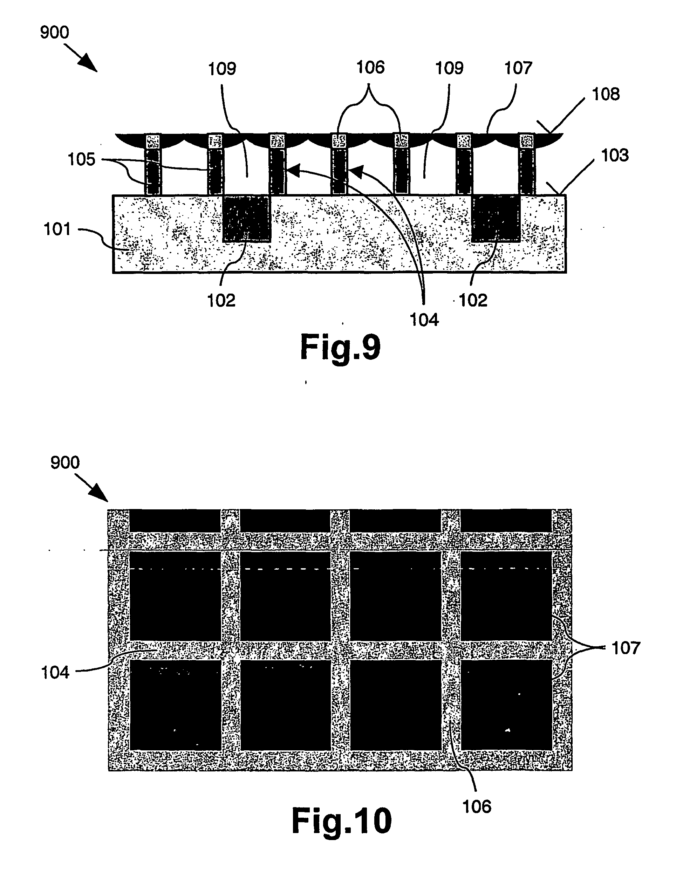

**Fig.9** zeigt einen Querschnitt durch eine noch nicht fertiggestellte Hohlraumstruktur 900 zu einem fünften Zeitpunkt während der Durchführung des Herstellungsverfahrens gemäß dem Ausführungsbeispiel der Erfindung.

Mittels eines chemisch-mechanischen Poliervorgangs wird die Schicht aus zugewachsenen Wülsten 801 derart abgetragen, dass die nebeneinander angeordneten Stege 104 an ihren Oberkanten wieder freigelegt werden und eine ebene Oberfläche parallel zur ersten Schichtoberfläche 103 entsteht. Diese ebene Oberfläche ist identisch mit der zweiten Schichtoberfläche 108. Aus der Schicht aus zugewachsenen Wülsten 801 wird somit die vierte Schicht 107 gebildet. Die zweite Schichtoberfläche 108 begrenzt folglich die dritte Schicht 106 und die vierte Schicht 107 parallel zur ersten Schichtoberfläche 103.

In **Fig.10** ist eine Draufsicht auf die Hohlraumstruktur 900 aus Fig.9 gezeigt. Mittels der vierten Schicht 107 werden die Hohlräume 109 zwischen den nebeneinander angeordneten Stegen 104 vollständig abgeschlossen. Somit ist nur noch die dritte Schicht 106 und die vierte Schicht 107 freigelegt, wobei die vierte Schicht 107 auf Grund der gewählten Gitterstruktur in mehrere, in der Draufsicht quadratische, Teilbereiche aufgeteilt wird.

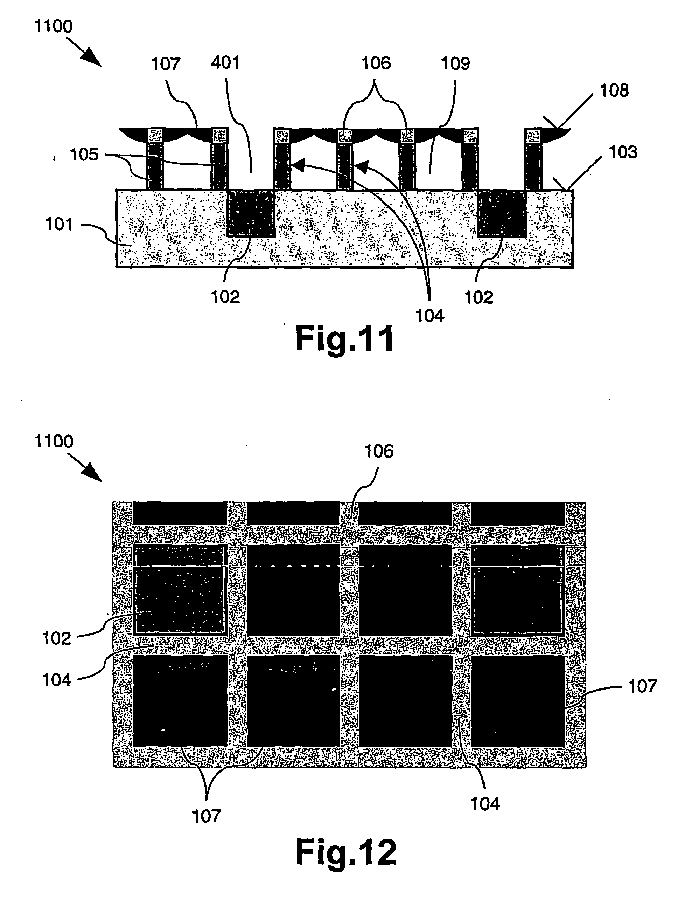

**Fig.11** zeigt einen Querschnitt durch eine noch nicht fertiggestellte Hohlraumstruktur 1100 zu einem sechsten Zeitpunkt während der Durchführung des Herstellungsverfahrens gemäß dem Ausführungsbeispiel der Erfindung.

Über einigen Hohlräumen 109 wird mittels einer weiteren Lithographie und einer weiteren Ätzung die vierte Schicht 107 wieder entfernt, wodurch dort die Zwischenräume 401 zwischen benachbart befindlichen nebeneinander angeordneten Stegen 104 wieder vollständig geöffnet werden.

Vorzugsweise werden die geöffneten, d.h. freigelegten, Zwischenräume 401 an ausgewählten Stellen über den Leiterbahnen 102 gebildet, wenn Leiterbahnen 102 an der ersten Schichtoberfläche 103 von der zweiten Schichtoberfläche 108 aus elektrisch kontaktiert werden sollen.

Zur Herstellung der elektrischen Kontakte 110 werden die geöffneten Zwischenräume 401 mit elektrisch leitfähigem Material gefüllt, bis das elektrisch leitfähige Material bündig mit der zweiten Schichtoberfläche 108 abschließt. Vorzugsweise erfolgt die Füllung der geöffneten Zwischenräume 401 mit elektrisch leitfähigem Material mittels eines konventionellen Metallisierungsprozesses. Daraus resultiert dann die in Fig.1 dargestellte Hohlraumstruktur 100.

Eine Herstellung von elektrischen Kontakten 110 kann beispielsweise dann notwendig werden, wenn über der erfindungsgemäßen Hohlraumstruktur 100 weitere Metallisierungsebenen zur Signalverarbeitung oder zum Signaltransport vorgesehen sind.

In **Fig.12** ist eine Draufsicht auf die Hohlraumstruktur 1100 aus Fig.11 gezeigt. Diese Draufsicht unterscheidet sich von der Draufsicht aus Fig.10 dadurch, dass zwischen einigen nebeneinander angeordneten Stegen 104 die vierte Schicht 107 nicht mehr vorhanden ist und somit die an der ersten Schichtoberfläche 103 angeordneten Leiterbahnen'102 sichtbar sind.

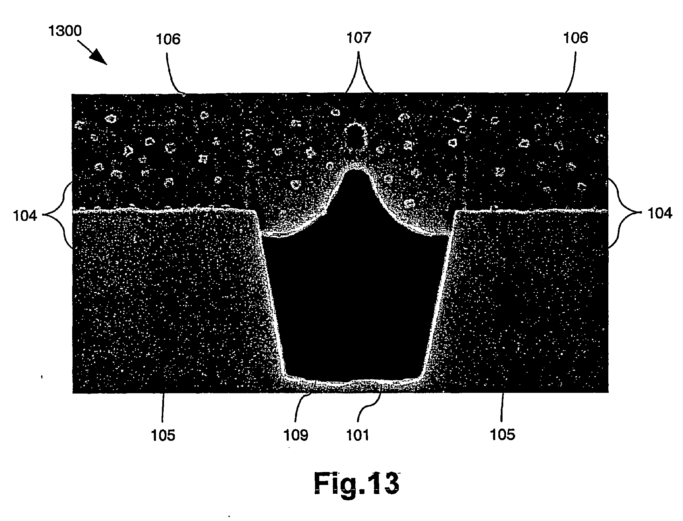

**Fig.13** zeigt einen vergrößerten Ausschnitt aus dem Querschnitt durch die Hohlraumstruktur 100 aus Fig.1. Dargestellt sind die nebeneinander angeordneten Stege 104, welche die zweite Schicht 105 und die dritte Schicht 106 aufweisen und auf der ersten Schicht 101 aufgebracht sind. Zwischen den nebeneinander angeordneten Stegen 104 ist selektiv an der dritten Schicht 106 die vierte Schicht 107 angeordnet, welche zusammen mit der ersten Schicht 101 und den nebeneinander angeordneten Stegen 104 den Hohlraum 109 einschließen. Die Form der den Hohlraum 109 bedeckenden vierten Schicht 107 lässt noch die Form der während der Bildung der vierten Schicht 107 entstandenen Wülste 601 erkennen.

In diesem Dokument ist folgende Veröffentlichung zitiert:
[1] J.G. Fleming, E. Roherty-Osmun, A.J. Farino, Conference Proceedings ULSI XII, Materials Research Society, p. 471-477, 1997
[2] T. Ueda, E. Tamaoka, K. Yamashita, N. Aoi, S. Mayumi, IEEE Proc. 1998 Symp. VLSI Techn. Digest of Technical Papers, p. 46-47, 1998

### Bezugszeichenliste

- 100: Hohlraumstruktur gemäß Erfindung
- 101: erste Schicht
- 102: integrierte Leiterbahn
- 103: erste Schichtoberfläche
- 104: nebeneinander angeordnete Stege
- 105: zweite Schicht
- 106: dritte Schicht
- 107: vierte Schicht
- 108: zweite Schichtoberfläche
- 109: Hohlraum
- 110: Kontakt
- 300: noch nicht fertiggestellte Hohlraumstruktur zu einem ersten Herstellungszeitpunkt
- 400: noch nicht fertiggestellte Hohlraumstruktur zu einem zweiten Herstellungszeitpunkt
- 401: Zwischenraum
- 600: noch nicht fertiggestellte Hohlraumstruktur zu einem dritten Herstellungszeitpunkt
- 601: Wulst
- 602: zuwachsende öffnung
- 800: noch nicht fertiggestellte Hohlraumstruktur zu einem vierten Herstellungszeitpunkt
- 801: Schicht aus zugewachsenen Wülsten
- 900: noch nicht fertiggestellte Hohlraumstruktur zu einem fünften Herstellungszeitpunkt
- 1100: noch nicht fertiggestellte Hohlraumstruktur zu einem sechsten Herstellungszeitpunkt
- 1300: Ausschnitt aus Hohlraumstruktur gemäß Erfindung

## Patentansprüche

1. Hohlraumstruktur (100) in einer integrierten Schaltung
• mit einer ersten Schicht (101) einer ersten Schichtoberfläche (103) und nebeneinander angeordneten Stegen (104) auf der ersten Schichtoberfläche (103)
• wobei die nebeneinander angeordneten Stege (104) zwischenräume (401) einschließen und eine zweite Schicht (105) eines ersten Isolationsmaterials und eine auf der zweiten Schicht (105) angeordnete dritte Schicht (106) eines zweiten Isolationsmaterials aufweisen,
• mit einer zumindest einige der Zwischenräume (401) abschließenden vierten Schicht (107) aus einem dritten Isolationsmaterial,
• bei der die vierte Schicht (107) auf der dritten Schicht (106) angeordnet ist und eine zweite Schichtoberfläche (108) aufweist, und
• bei der Zwischenräume, die nicht mittels der vierten Schicht (107) abgeschlossen sind, mit elektrisch leitendem Material angefüllt sind,
dadurch gekennzeichneit, dass sich das dritte Isolationsmaterial nicht auf dem ersten Isolationsmaterial abscheiden lässt.

2. Hohlräumstruktur gemäß Anspruch 1,
bei der die abgeschlossenen Zwischenräume Hohlräume (109) zwischen den nebeneinander angeordneten stegen (104), der ersten Schichtoberfläche (103) und der vierten Schicht (107) bilden.

3. Hohlraumstruktur gemäß einem der Ansprüche 1 bis 2,
bei der die erste Schichtoberfläche (103) teilweise elektrisch leitend ist.

4. Hohlraumstruktur gemäß einem der Ansprüche 1 bis 3,
bei der die mit elektrisch leitendem Material angefüllten Zwischenräume als Kontakte (110) zwischen der ersten Schichtoberfläche (103) und der zweiten Schichtoberfläche (108) ausgebildet sind.

5. Hohlraumstruktur gemäß einem der Ansprüche 1 bis 4,
bei der die nebeneinander angeordneten Stege (104) gitterförmig angeordnet sind.

6. Hohlraumstruktur gemäß einem der Ansprüche 1 bis 5,
bei der die nebeneinander angeordneten Stege (104) und Hohlräume (109), eine ebene Hohlraumstruktur einer ebenen zweiten Schichtoberfläche (108) bilden und mehrere dieser ebenen Hohlraumstrukturen übereinander angeordnet sind.

7. Verfahren zur Herstellung einer Hohlraumstruktur (100) in einer integrierten Schaltung,
• Bei dem eine zweite Schicht (105) aus einem ersten Isolationsmaterial auf einer ersten Schichtoberfläche (103) einer ersten Schicht (101) aufgebracht wird,
• bei dem eine dritte Schicht (106) aus einem zweiten Isolationsmaterial auf der zweiten Schicht (105) aufgebracht wird, wobei die dritte Schicht (106) eine zu der ersten Schichtoberfläche (103) parallel angeordnete zweite Schichtoberfläche (108) erhält,
• bei dem aus der zweiten Schicht (105) und der dritten Schicht (106) nebeneinander angeordnete Stege (104) mit Zwischenräumen (401) gebildet werden,
• bei dem ein drittes Isolationsmaterial an den nebeneinander angeordneten Stegen (104) selektiv auf der dritten Schicht (106) aufgebracht wird, wodurch eine vierte Schicht (107) zwischen und über den nebeneinander angeordneten Stegen (104) gebildet wird,
• bei dem parallel zur ersten Schichtoberfläche (103) die vierte Schicht (107) teilweise entfernt wird, bis die zweite Schichtoberfläche (108) freigelegt ist, und
• bei dem über einigen Zwischenräumen die vierte Schicht (107) vollständig entfernt wird und diese Zwischenräume (401) mit elektrisch leitendem material zur Bildung von elektrischen Kontakten (110) zwischen der ersten Schichtoberfläche (103) und der zweiten Schichtoberfläche (108) gefüllt werden, wodurch sich eine Hohlraumstruktur ergibt.

8. Verfahren gemäß Anspruch 7,
bei dem die nebeneinander angeordneten Stege (104) mittels Lithographie und Ätzung erzeugt werden.

9. Verfahren gemäß Anspruch 7 oder 8,
bei dem mittels der selektiven Abscheidung des dritten Isolationsmaterials in den Zwischenräumen Hohlräume (109) zwischen den nebeneinander angeordneten Stegen (104), der ersten Schichtoberfläche (103) und der vierten Schicht (107) gebildet werden.

10. Verfahren gemäß einem der Ansprüche 7 bis 9,
bei dem zur Freilegung der dritten Schicht (106) die vierte Schicht (107) mittels chemisch-mechanischen Polierens teilweise entfernt wird.

11. Verfahren gemäß einem der Ansprüche 7 bis 10,
bei dem zur Freilegung einiger Zwischenräume die vierte Schicht (107) über den Zwischenräumen mittels Lithographie und Ätzung entfernt wird, wodurch diese Zwischenräume (401) wieder geöffnet werden.

## Claims

1. A pattern of voids (100) in an integrated circuit,
• having a first layer (101), a first layer surface (103) and adjacent lands (104) on the first layer surface (103),
• the adjacent lands (104) enclosing spaces (401) and including a second layer (105) of a first isolation material and a third layer (106) of a second isolation material arranged on the second layer (105),
• having a fourth layer (107) of a third isolation material which closes off at least some of the spaces (401),
• in which the fourth layer (107) is arranged on the third layer (106) and has a second layer surface (108), and
• in which spaces which are not closed off by means of the fourth layer (107) are filled with electrically conductive material,
• **characterized in that** the third isolation material cannot be deposited on the first isolation material.

2. The pattern of voids as claimed in claim 1,
in which the spaces which are closed off form voids (109) between the adjacent lands (104), the first layer surface (103) and the fourth layer (107).

3. The pattern of voids as claimed in one of claims 1 to 2,
in which the first layer surface (103) is partially electrically conductive.

4. The pattern of voids as claimed in one of claims 1 to 3,
in which the spaces filled with electrically conductive material are formed as contacts (110) between the first layer surface (103) and the second layer surface (108).

5. The pattern of voids as claimed in one of claims 1 to 4,
in which the adjacent lands (104) are arranged in grid form.

6. The pattern of voids as claimed in one of claims 1 to 5,
in which the adjacent lands (104) and voids (109) form a planar pattern of voids with a planar second layer surface (108), and a plurality of these planar patterns of voids are arranged above one another.

7. A method for producing a pattern of voids (100) in an integrated circuit,
• in which a second layer (105) of a first isolation material is applied to a first layer surface (103) of a first layer (101),
• in which a third layer (106) of a second isolation material is applied to the second layer (105), the layer (106) acquiting a second layer surface (108) which is arranged parallel to the first layer surface (103),
• in which adjacent lands (104) with spaces (401) are formed from the second layer (105) and the third layer (106),
• in which a third isolation material, on the adjacent lands (104), is applied selectively to the third layer (106), with the result that a fourth layer (107) is formed between and above the adjacent lands (104),
• in which, parallel to the first layer surface (103), the fourth layer (107) is partially removed until the second layer surface (108) is uncovered, and
• in which the fourth layer (107) is completely removed above some spaces, and these spaces (401) are filled with electrically conductive material in order to form electrical contacts (110) between the first layer surface (103) and the second layer surface (108), resulting in a pattern of voids.

8. The method as claimed in claim 7,
in which the adjacent lands (104) are produced by means of lithography and etching.

9. The method as claimed in claim 7 or 8,
in which voids (109) are formed between the adjacent lands (104), the first layer surface (103) and the fourth layer (107) by means of the selective deposition of the third isolation material in the spaces.

10. The method as claimed in one of claims 7 to 9,
in which the fourth layer (107) is partially removed by means of chemical-mechanical polishing in order to uncover the third layer (106).

11. The method as claimed in one of claims 7 to 10,
in which, to uncover some spaces, the fourth layer (107) is removed above the spaces by means of lithography and etching, so that these spaces (401) are opened up again.

## Revendications

1. Structure (100) creuse dans un circuit intégré
• comprenant une première couche (101), une première surface (103) de couche et des nervures (104) disposées les unes à côté des autres sur la première surface (103) de couche,
• dans laquelle, les nervures (104) disposées les unes à côté des autres enferment des espaces (401) intermédiaires et comportent une deuxième couche (105) d'une première matière isolante et une troisième couche (106) d'une deuxième matière isolante disposée sur la deuxième couche (105),
• comprenant une quatrième couche (107) en une matière isolante fermant au moins certains des espaces (401) intermédiaires,
• dans laquelle la quatrième couche (107) est disposée sur la troisième couche (106) et comporte une deuxième surface (108) de couche, et
• dans laquelle des espaces intermédiaires qui ne sont pas fermés au moyen de la quatrième couche (107) sont garnis d'une matière conductrice de l'électricité, **caractérisée en ce que** la troisième matière isolante ne peut pas être déposée sur la première matière isolante.

2. Structure creuse suivant la revendication 1,
dans laquelle les espaces intermédiaires fermés forment des cavités (109) entre les nervures (104) disposées les unes à côté des autres, la première surface (103) de couche et la quatrième couche (107).

3. Structure creuse suivant l'une des revendications 1 à 2,
dans laquelle la première surface (103) de couche est conductrice de l'électricité, au moins en partie.

4. Structure creuse suivant l'une des revendications 1 à 3,
dans laquelle les espaces intermédiaires garnis de matière conductrice de l'électricité sont constitués sous la forme de contacts (100) entre la première surface (103) de couche et la deuxième surface (108) de couche.

5. Structure creuse suivant l'une des revendications 1 à 4,
dans laquelle les nervures (104) disposées les unes à côté des autres sont disposées sous la forme d'une grille.

6. Structure creuse suivant l'une des revendications 1 à 5,
dans laquelle les nervures (104) disposées les unes à côté des autres et les cavités (109) forment une structure creuse ayant une deuxième surface (108) de couche plane et plusieurs de ces structures creuses sont disposées les unes au-dessus des autres.

7. Procédé de producticn d'une structure (100) creuse dans un circuit intégré,
• dans lequel on dépose une deuxième couche (105) en une première matière isolante sur une première surface (103) de couche d'une première couche (101)
• dans lequel on dépose une troisième couche (105) en une deuxième matière isolante sur la deuxième couche (105), la troisième couche (106) comportant une deuxième surface (108) de couche disposée parallèlement à la première surface (103) de couche,
• dans lequel on forme des nervures (104) ayant des espaces (401) intermédiaires disposées les unes à côté des autres à partir de la deuxième couche (105) et de la troisième couche (106),
• dans lequel on dépose sélectivement sur la troisième couche (106) une troisième matière isolante sur les nervures (104) disposées les unes à côté des autres, en formant ainsi une quatrième couche (107) entre et sur les nervures (104) disposées les unes à côté des autres,
• dans lequel on élimine en partie la quatrième couche (107) parallèlement à la première surface (103) de couche jusqu'à mettre à nu la deuxième surface (108) de couche, et
• dans lequel, on élimine complètement la quatrième couche (107) sur certains des espaces intermédiaires et l'on garnit ces espaces (401) intermédiaires de matière conductrice de l'électricité pour la formation de contacts (110) électriques entre la première surface (103) de couche et la deuxième surface (108) de couche, en obtenant ainsi une structure creuse.

8. Procédé suivant la revendication 7,
dans lequel on produit les nervures (104) disposées les unes à côté des autres au moyen d'une lithographie et d'une attaque chimique.

9. Procédé suivant la revendication 7 ou 8,
dans lequel on forme, au moyen du dépôt sélectif de la troisième matière isolante, dans les espaces intermédiaires, des cavités (109) entre les nervures (104) disposées les unes à côté des autres, la première surface (103) de couche et la quatrième couche (107).

10. Procédé suivant l'une des revendications 7 à 9,
dans lequel pour la mise à nu de la troisième couche (106), on élimine en partie la quatrième couche (107) au moyen d'un polissage chémiomécanique.

11. Procédé suivant l'une des revendications 7 à 10,
dans lequel pour la mise à nu de certains' espaces intermédiaires, on élimine la quatrième couche (107) au-dessus des espaces intermédiaires au moyen d'une lithographie et d'une attaque chimique en réouvrant ainsi ces espaces (401) intermédiaires,
